# EUROPÄISCHE PATENTSCHRIFT

(11) **EP 1 642 169 B1**
(45) Veröffentlichungstag und Bekanntmachung des Hinweises auf die Patenterteilung: **16.05.2007**
(21) Anmeldenummer: 04738841.8
(22) Anmeldetag: 01.07.2004
(51) Int. Cl.: G03B 27/08, G03F 7/20, G03F 1/00, B24D 15/10, B41M 3/14

(54) **BELICHTUNGSSTATION FÜR FOLIENBAHNEN**
EXPOSURE STATION FOR FILM WEBS
POSTE D'EXPOSITION POUR BANDES DE FILM

(30) Priorität: 04.07.2003 DE 10330421
(43) Veröffentlichungstag der Anmeldung: 05.04.2006
(73) Patentinhaber: Leonhard Kurz GmbH & Co. KG, 90763 Fürth (DE)
(72) Erfinder: KATSCHOREK, Haymo, 90587 Obermichelbach (DE); SEITZ, Mathias, 91054 Buckenhof (DE)
(74) Vertreter: Zinsinger, Norbert
(86) Internationale Anmeldenummer: PCT/DE2004/001398
(87) Internationale Veröffentlichungsnummer: WO 2005/006075

(56) Entgegenhaltungen:
- GB-A- 434 434
- GB-A- 580 315
- GB-A- 1 298 228
- US-A- 5 083 850
- US-A- 5 624 773
- US-A- 5 933 219
- US-B1- 6 440 277

## Beschreibung

Die Erfindung betrifft eine Belichtungsstation für die Erzeugung von partiell ausgebildeten Bereichen in einer oder in mehreren Schichten einer Folienbahn, die über ein oder mehrere Strahlungsquellen zur Belichtung der Folienbahn verfügt. Die Erfindung betrifft weiter ein Sicherungselement mit partiell ausgebildeten Bereichen, das mit einer derartigen Belichtungsstation hergestellt ist.

Mehrschichtfolien mit partiell demetallisierten Schichten haben vielfältige Anwendungsmöglichkeiten. Sie können beispielsweise zur Dekoration von Substrat-Oberflächen oder auch im Sicherheitsbereich zur Sicherung von Dokumenten, Karten und Geldscheinen Verwendung finden.

In GB 2136352A wird der Einsatz einer solchen Mehrschichtfolie für den Sicherheitsbereich beschrieben, wobei eine partielle Demetallisierung mittels Aufdrucken einer dünnen Fimisschicht vor der eigentlichen Demetallisierung erzielt wird:

Die Mehrschichtfolie dient hier als Siegel, das auf zwei Oberflächen aufgebracht wird. Wenn diese beiden Oberflächen nach dem Aufbringen des Siegels voneinander entfernt werden, wenn so beispielsweise eine Verpackung einer Videokassette geöffnet wird, so wird dieses Siegel zerstört und damit das Öffnen der Verpackung kenntlich gemacht.

Dieses Sicherheitsprodukt wird hierbei wie folgt hergestellt:

Eine Plastikschicht aus transparentem Polyester wird mit einer Lackschicht bedruckt. In die derart erzeugte Lackschicht wird ein Sicherheitshologramm eingeprägt. Als nächster Schritt folgt eine ganzflächige Metallisierung der Oberfläche, in die das Sicherheitshologramm eingeprägt worden ist. Anschließend erfolgt eine partielle Demetallisierung dieser Oberfläche.

Die partielle Demetallisierung wird dadurch erreicht, daß auf diejenigen Bereiche der dünnen Metallschicht, die nach einer Demetallisierung verbleiben sollen, ein schützender Firnis aufgedruckt wird. Anschließend erfolgt die eigentliche Demetallisierung, bei der nun nur diejenigen Bereiche der dünnen Metallschicht entfernt werden, die nicht von der Fimisschicht geschützt sind.

An die Demetallisierung anschließend erfolgt ein Waschprozeß. In den darauf folgenden Schritten wird eine Klebeschicht aufgetragen und die so entstandene Mehrschichtfolie in kleine Stücke geschnitten, die jeweils die Funktion des oben beschriebenen Siegels erbringen können.

In DE 43 29 803 A1 wird ein Maskenprojektionsbelichter zur Belichtung von Objekten in einem Lithographieprozess bei der Halbleiterbauelementherstellung beschrieben. Eine Photoresistschicht wird auf einem Quarzwafer in einer Schichtdicke von 0,1 µm bis 1 µm aufgebracht. Der Quarzwafer wird nun durch eine Gittermaske belichtet. Die Gittermaske besteht aus einem Gittermaskenträger und einer darauf gebildeten Gitterstruktur. Der Gittermaskenträger besteht aus Quarz, Sodakalkglas oder Borsilikatglas. Die Gitterstruktur wird unter Verwendung eines Photoresists, durch Strukturierung unter Benutzung einer aufgeschleuderten Glassicht oder durch Strukturierung der Rückseite eines aus Glas bestehenden Gittermaskenträgers erzeugt.

Der Erfindung liegt nun die Aufgabe zugrunde, Belichtungsverfahren zu verbessern.

Diese Aufgabe wird von einer Belichtungsstation zur Erzeugung von partiell ausgebildeten Bereichen in einer oder in mehreren Schichten einer Folienbahn gelöst, bei der die Belichtungsstation eine oder mehrere Strahlungsquellen zur Belichtung der Folienbahn aufweist, weiter ein Maskenband mit partiell ausgeformten Bereichen mit unterschiedlichen optischen Eigenschaften aufweist, weiter zwei oder mehr Führungen zur Führung des Maskenbandes und/oder zur Führung der Folienbahn aufweist, die so angeordnet sind, dass das Maskenband in einem Belichtungsbereich im Strahlungsgang zwischen den ein oder mehreren Strahlungsquellen und der Folienbahn geführt ist. Das Maskenband wird im Belichtungsbereich vorzugsweise parallel zur Folienbahn geführt. Es ist jedoch auch möglich, dass das Maskenband quer oder schräg zur Folienbahn geführt wird (Quer- oder Schrägbelichtung) und weiter Kopplungsmittel zur Bewegung des Maskenbandes im Belichtungsbereich mit der Geschwindigkeit der Folienbahn aufweist.

Dabei weist das Maskenband eine Trägerschicht aus für Strahlung der einen oder mehreren Strahlungsquellen durchlässigem Material auf und besitzt
a) partiell ausgeformte Bereiche mit unterschiedlichen optischen Brechungsindizes und/oder
b) partiell ausgeformte Bereiche mit unterschiedlichen Polarisationseigenschaften und/oder
c) eine partiell ausgeformte reflektive Schicht, die Bereiche mit unterschiedlichen reflektiven Eigenschaften besitzt.

Durch die Erfindung werden eine Vielzahl von Vorteilen erzielt:

Es wird hierdurch möglich, mittels eines einzigen Belichtungsschrittes partiell ausgebildete Bereiche in einer oder in mehreren Schichten einer Folienbahn in einem kontinuierlichen Fertigungsprozess von Rolle zu Rolle zu erzeugen. Hierdurch wird die Anzahl der Prozess-Schritte zur Herstellung einer derartigen Folienbahn reduziert und damit das Herstellungsverfahren beschleunigt und verbilligt. Weiter ist es so möglich, selbst bei hohen Verarbeitungsgeschwindigkeiten partiell ausgebildete Bereiche mit hoher Präzision und hoher Auflösung herzustellen.

Weitere Vorteile sind, dass durch die Erfindung eine flexible Erstellung (Personalisierung) von Teildemetallisierungen und eine flexible Belichtung von Photoresist zur Personalisierung ermöglicht wird.

Vorteilhafte Ausgestaltungen der Erfindung sind in den Unteransprüchen bezeichnet.

Es ist vorteilhaft, dass die Belichtungsstation eine Insetting-Vorrichtung aufweist, die die Position des Maskenbandes zur Folie derart verändert, dass die Belichtung im Register erfolgt. Durch eine derartige Vorrichtung entfällt die manuelle Einstellung und Nachsteuerung der Belichtungsstation und es wird ein konstant qualitativ hochwertiges Belichtungsergebnis erzielt.

Als Maskenband kann eine Endlosband oder ein von Rolle zu Rolle geführtes offenes Maskenband verwendet werden. Insbesondere bei Verwendung eines offenen Maskenbandes ergibt sich der Vorteil, daß das Maskenband mit personalisierten Musterbereichen versehen sein kann, so dass mittels der Belichtungsstation eine Personalisierung von Sicherungselementen durchgeführt werden kann. So kann das Maskenband beispielsweise mit individuell wechselnden Daten (Bilder, Zahlen, Codes) bedruckt sein. Als Druckverfahren hierzu finden vorzugsweise digitale Druckverfahren wie Tintenstrahl- oder LaserDruck Verwendung. Auch der TTF-Druck kann zum Bedrucken des Maskenbandes eingesetzt werden. Weiterhin ist es möglich, das Maskenband mittels Laserbestrahlung mit wechselnden Daten zu beschreiben (Bleichen, Schwärzen, Laserablation).

Weitere Vorteile sind durch die Verwendung eines wiederbeschreibbaren Maskenbandes erzielbar. Eine derartiges Maskenband weist beispielsweise eine Schicht aus einem thermochromen Material auf.

Es ist zweckmässig, dass die Belichtungsstation eine Spannvorrichtung zur Spannung des Maskenbandes aufweist. Durch eine derartige Spannvorrichtung wird ein sicherer Lauf des Maskenbandes gewährleistet und damit die Qualität der mittels der Belichtungsstation hergestellten Elemente verbessert.

Gemäss einer bevorzugten Ausführungsform der Erfindung werden die Kopplungsmittel von mindestens einer Rolle gebildet, über die die Folienbahn und das Maskenband übereinander liegend geführt sind, so dass das Maskenband mit der Folienbahn mittransportiert wird. Hierdurch ist ein besonders kostengünstiger und einfacher Aufbau der Belichtungsstation möglich. Eine besonders präzise Kopplung zwischen der Bewegung des Maskenbandes und der Folienbahn wird hierbei dadurch erzielt, dass zwei beidseitig des Belichtungsbereiches angeordnete Rollen zur Führung der Folienbahn und des Maskenbandes vorgesehen sind und zwei weitere beidseitig des Belichtungsbereiches angeordnete Rollen zur Führung des Maskenbandes und zur Erzeugung eines Anpressdruckes zwischen Maskenband und Folienband vorgesehen werden.

Gemäss eines weiteren bevorzugten Ausführungsbeispieles der Erfindung weist die Belichtungsstation eine Antriebseinrichtung zur Bewegung des Maskenbandes mit einer ersten Geschwindigkeit auf. Weiter werden die Kopplungsmittel von einer die Antriebseinrichtung ansteuernden Steuereinrichtung gebildet, die die erste Geschwindigkeit mit der Geschwindigkeit der Folienbahn synchronisiert. Neben der Verwendung von mechanischen Kopplungsmitteln ist demnach auch die Verwendung von elektronischen Kopplungsmitteln möglich, die die Geschwindigkeit der Maskenbahn mit der Geschwindigkeit der Folienbahn synchronisieren. Eine derartige "elektronische" Kopplung erfordert die Ausstattung der Belichtungsstation mit zusätzlichen Komponenten, was den Aufbau der Belichtungsstation verteuert. Andererseits ergeben sich jedoch aus technischer Sicht hierdurch mehrere Vorteile: Zum einen ist kein direkter Kontakt zwischen Folienbahn und Maskenband erforderlich, so dass keine Kontaktreaktionen stattfinden können und die eventuell empfindliche Folienbahn-Oberfläche nicht durch Reibung oder Abrieb beansprucht wird. Insbesondere, wenn die Belichtungsstation über einen grossen Belichtungsbereich verfügen soll und die Folienbahn mit hoher Geschwindigkeit bewegt werden soll, kommen diese Vorteile einer elektronischen Kopplung zum Tragen.

Das Material des Maskenbandes ist hierbei an den Verwendungszweck (Endlosband, Rolle zu Rolle, direkter Kontakt mit Folienbahn/ kein direkter Kontakt mit Folienbahn), Strahlungsquelle (Wellenlängendurchlässigkeit) und Art des verwendeten Lichts (polarisiert; Träger dann nicht polarisierend oder mit definierter Doppelbrechung) anzupassen.

Es ist zweckmässig, dass das Maskenband einen sich zwei oder mehrfach wiederholenden Musterbereich aufweist. Damit kann ein theoretisch unbegrenzt grosser Belichtungsbereich vorgesehen werden. Mit der Vergrösserung des Belichtungsbereiches ist es möglich, die Geschwindigkeit der Folienbahn und damit die Verarbeitungsgeschwindigkeit zu erhöhen.

Bezüglich des Ausformung des Maskenbandes haben sich verschiedene Möglichkeiten als vorteilhaft erwiesen: So ist es möglich, dass das Maskenband partiell ausgeformte Bereiche mit unterschiedlichen transparenten und reflektiven Eigenschaften besitzt. Weiter ist es möglich, dass das Maskenband partiell ausgeformte Bereiche mit unterschiedlichen optischen Brechungsindizes besitzt. Weiter ist es möglich, dass das Maskenband partiell ausgeformte Bereiche mit unterschiedlichen Polarisationseigenschaften besitzt. Es ist natürlich auch möglich, dass das Maskenband sowohl partiell ausgeformte Bereiche mit unterschiedlichen transparenten und reflektiven Eigenschaften, mit unterschiedlichen optischen Brechungsindizes und mit unterschiedlichen Polarisationseigenschaften besitzt. Mittels eines derartigen Maskenbandes können dann unter Umständen mehrere Belichtungsschritte gleichzeitig mittels ein und derselben Belichtungsstation erbracht werden.

Um den Belichtungsprozess präzise adaptieren zu können, weist die Belichtungsstation vorzugsweise einen optischen Filter auf, der in dem Strahlengang zwischen Lichtquelle und Maskenband angeordnet ist.

Weiter hat sich auch der Einsatz eines Kollimators als vorteilhaft erwiesen, der in dem Strahlengang zwischen ein oder mehreren Lichtquellen und dem Maskenband angeordnet ist. Mittels eines derartigen Kollimators lässt sich auch der Abstand zwischen Maskenband und Folienbahn im Belichtungsbereich vergrössern, ohne Qualitätseinbussen hinnehmen zu müssen. Weitere Vorteile lassen sich durch Kombination unterschiedlicher Filter erzielen, beispielsweise durch Kombination eines optischen Bandpassfilters, eines Kollimators und eines Polarisators.

Es ist zweckmässig, als Strahlungsquelle eine UV-Lampe zu verwenden. Weiter ist auch die Verwendung anderer Strahlungsquellen, die beispielsweise IR-Strahlung, ES-Strahlung oder sichtbares Licht abstrahlen, denkbar. Weiter ist es zweckmässig, dass die Belichtungsstation eine Abschirmung aufweist, die so ausgeformt ist, dass sie die Strahlung der Strahlungsquelle von den Bereichen der Folie abschirmt, die sich nicht im Belichtungsbereich befinden. Hierdurch wird die Qualität des Produktionsergebnisses verbessert.

Die erfindungsgemässe Belichtungsstation eignet sich vorzüglich zur Herstellung von Elementen mit optischen Sicherungsmerkmalen zur Sicherung von Banknoten, Kreditkarten und dergl.. Weiter eignet sich die Belichtungsstation vor allem zur Herstellung von Folien, insbesondere Prägefolien, Laminierfolien oder Stickerfolien.

Im folgenden wird die Erfindung anhand von mehreren Ausführungsbeispielen unter Zuhilfenahme der beiliegenden Zeichnungen beispielhaft erläutert.
Fig. 1 zeigt eine schematische Darstellung einer erfindungsgemässen Belichtungsstation für ein erstes Ausführungsbeispiel.
Fig. 2 zeigt einen Schnitt durch ein Maskenband zur Verwendung in der Belichtungsstation nach Fig. 1.
Fig. 3 zeigt eine schematisierte Draufsicht auf ein Maskenband zur Verwendung in der Belichtungsstation nach Fig. 1.
Fig. 4 zeigt eine schematische Darstellung einer erfindungsgemässen Belichtungsstation gemäss eines zweiten Ausführungsbeispieles der Erfindung.
Fig. 5 zeigt eine schematische Darstellung einer erfindungsgemässen Belichtungsstation gemäss eines dritten Ausführungsbeispieles der Erfindung.

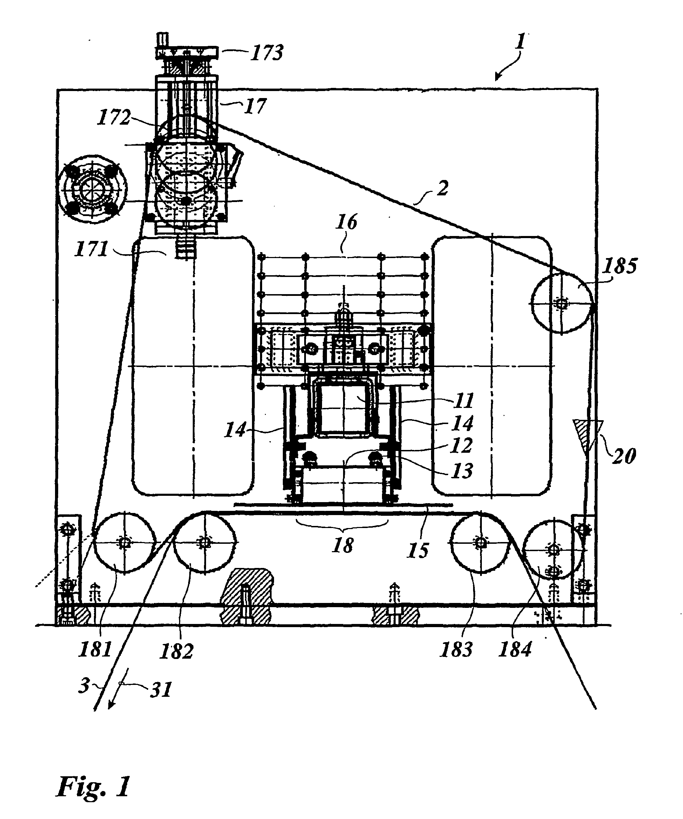

Fig. 1 zeigt eine Belichtungsstation 1 mit einem Maskenband 2, mehreren Rollen 181, 182, 183, 184, 185 und 172, mit einer Spannvorrichtung 17, mit einem Abschirmblech 15, mit einer Strahlungsquelle 11, mit einer Haltevorrichtung 16, mit einem Filter 12, mit einer Haltevorrichtung 13 und mit zwei Führungsschienen 14.

Das Maskenband 2 ist über die Rollen 181, 182, 183, 184, 185 und 172, wie in Fig. 1 dargestellt, geführt. Die Rollen 181, 182, 183, 184, 185 und 172 wirken so als Führungen zur Führung des Maskenbandes 2. Anstelle des Einsatzes von Rollen als Führungen ist es natürlich auch möglich, das Maskenband 2 über Stäbe, Ablenkbleche und Führungsflächen zu führen.

Die Rolle 172 ist Teil der Spannvorrichtung 17. Die Spannvorrichtung 17 ist über ein Gewinde 171 mit einem Träger der Belichtungsstation 1 verbunden. Durch Drehung eines Einstellrades 173 ist es möglich, den Abstand der Spannvorrichtung 17 von dem Träger der Belichtungsstation 1 zu verändern und damit die Position der Rolle 172, wie in Fig. 1 gezeigt, zu verändern. Durch die Veränderung der Position der Rolle 172 wird die Spannung des Maskenbandes 2 und damit der Anpressdruck zwischen den Rollen 181, 182, 183, 184, 185 und 172 und dem Maskenband 2 verändert.

Weiter ist es hier auch möglich, dass die Spannvorrichtung weiter ein Federelement aufweist, über das das Lager der Rolle 172 federnd gelagert ist. Hierdurch ist es möglich, den Anpressdruck noch präziser einzustellen.

Wie in Fig. 1 dargestellt, handelt es sich bei dem Maskenband 2 um ein Endlosband, das über Rollen in der mittels eines Pfeiles 20 angezeigten Richtung bewegt wird. Über die Rollen 182 und 183 ist, wie in Fig. 1 angedeutet, zusätzlich eine Folienbahn 3 in der durch einen Pfeil 31 gezeigten Richtung geführt. Über die Rollen 182 und 183 sind demnach die Folienbahn 3 und das Maskenband 2 übereinander liegend geführt, so dass das Maskenband 2 durch die Bewegung der Folienbahn 3 in die durch den Pfeil 31 angezeigte Richtung mittransportiert wird.

In einem Belichtungsbereich 18 sind demnach das Maskenband 2 und die Folienbahn 3 übereinander liegend und demnach parallel zueinander mittels der Rollen 182 und 183 geführt. Beidseitig des Belichtungsbereiches 18 sind die Rollen 182 und 183 angeordnet, über die die Folienbahn 3 und das Maskenband 2 geführt sind, und die Rollen 181 und 184 angeordnet, über die lediglich das Maskenband 2 geführt ist. Durch die Anordnung der Rollen 181 und 182 bzw. 183 und 184 auf gleicher Höhe und durch die in Fig. 1 gezeigte Art der Führung des Maskenbandes 2 und der Folienbahn 3 über diese Rollen wird erreicht, dass mittels der Spannvorrichtung 17 der Anpressdruck zwischen dem Maskenband 2 und der Folienbahn 3 im Bereich der Führung des Maskenbandes 2 und der Folienbahn 3 über die Rolle 182 bzw. 183 einstellbar ist.

Der Anpressdruck wird hierbei derart eingestellt, dass eine genügend hohe Haftreibung zwischen der Folienbahn 3 und dem Maskenband 2 im Bereich der Rollen 182 bzw. 183 erzielt wird, so dass ein ruckfreier und sicherer Mittransport des Maskenbandes 2 mit der Folienbahn 3 möglich ist.

Die Haltevorrichtung 16 dient der höhenverstellbaren Fixierung der Strahlungsquelle 11. Die Strahlungsquelle 11 wird von einer UV-Lampe, einer elektrischen Fassung zur Herstellung eines elektrischen Kontaktes zwischen dem Lampenkörper und dem Stromanschluss der Belichtungsstation 1 und einer Abschirmung gebildet, die den Lampenkörper auf der der Folienbahn 3 gegenüberliegenden Seite optisch abschirmt. Anstelle einer UV-Lampe ist es auch möglich, eine sichtbares Licht, IR-Strahlen oder ES-Strahlen abstrahlende Strahlungsquelle zu verwenden. Diese Abschirmung wird hierbei vorzugsweise reflektiv ausgestaltet.

Die Strahlungsquelle 11 wird weiter über Schlitten in den Führungsschienen 14 geführt, so dass der Abstand der Strahlungsquelle 11 zu der Folienbahn 3 verändert werden kann. Damit ist die Strahlungsquelle 11 sowohl mittels der Haltevorrichtung 16 höhenverstellbar, als auch aufgrund der Lagerung in den Führungsschienen 14 in Bezug auf den Abstand zu der Folienbahn 3 verstellbar.

Bei dem Filter 12 handelt es sich um einen optischen Bandpass-Filter mit dem das auf das auf die Folienbahn einwirkende Frequenzband eingestellt werden kann. Bei dem Filter 12 kann es sich jedoch auch um einen beliebigen anderen optischen Filter, beispielsweise einen Polarisations-Filter oder um einen Kollimator, handeln. Der Filter 12 wird hierbei mittels der Haltevorrichtung 13 höhenverstellbar fixiert.

Es ist natürlich auch möglich, auf den Filter 12 und die Haltevorrichtung 13 zu verzichten.

Der Belichtungsbereich 18 der Belichtungsstation 1 hat eine Länge von 40 bis 50 cm. Es ist jedoch auch möglich, je nach Anforderung, den Belichtungsbereich 18 länger oder kürzer zu gestalten. Je nach Länge des Belichtungsbereiches 18 ist hierbei der Einsatz von ein oder mehreren Strahlungsquellen vorzusehen.

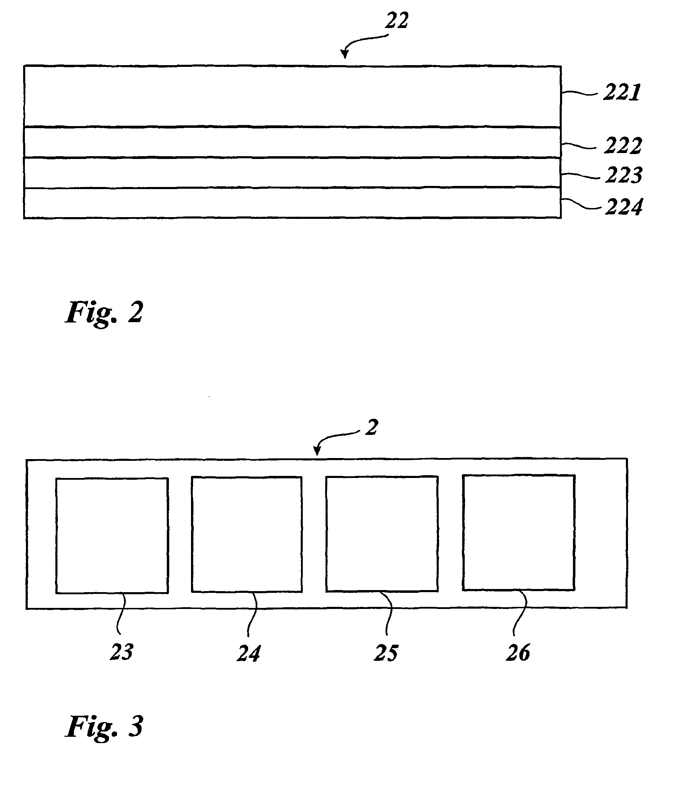

Der prinzipielle Aufbau des Maskenbandes 2 wird nun anhand von Fig. 2 verdeutlicht:

Fig. 2 zeigt einen Schnitt durch ein Maskenband 22. Das Maskenband 22 weist vier Schichten 221, 222, 223 und 224 auf.

Bei der Schicht 221 handelt es sich um eine Trägerschicht, die für den hier massgeblichen Wellenlängenbereich der Strahlungsquelle 11 durchlässig ist. Die Trägerschicht besteht aus einem 50 µm TAC-Trägerfilm, der oberhalb von 315 nm durchlässig ist. Es ist jedoch auch möglich, alternativ hierzu die Trägerschicht aus einem PET-Träger oder einem Träger aus einem sonstigen, flexiblen und im interessierenden Wellenlängenbereich der Strahlungsquelle 11 strahlungsdurchlässigen Material zu verwenden. Vorzugsweise sollte eine Durchlässigkeit im Wellenlängenbereich von 280 bis 400 nm gegeben sein. So besteht die Schicht 221 beispielsweise aus einem 12 µm dicken PET-Träger.

Die Schicht 222 stellt eine Replizierschicht dar, die vorzugsweise aus einem transparenten, thermoplastischen Kunststoffmaterial besteht.

Der Replizierlack wird vorzugsweise mit einer Linienraster-Tiefdruckwalze aufgetragen und dann durch Trocknung in einem Trocknungskanal bei einer Temperatur von 100 bis 120 °C getrocknet.

In die Replizierschicht 222 wird nun mittels eines Prägewerkzeuges eine Struktur eingeprägt, so dass die Schicht 222 als Orientierungsschicht für die sodann aufgetragene Schicht 223 aus einem LCP-Material wirkt.

Neben dem Aufbau eines Maskenbandes gemäss der Fig. 2, bei dem das Maskenband partiell ausgeformte Bereiche mit unterschiedlichen Polarisationseigenschaften besitzt, ist es auch möglich, Maskenbänder einzusetzen, die partiell ausgeformte Bereiche mit unterschiedlichen transparenten/reflektiven Eigenschaften oder mit unterschiedlichen optischen Brechungsindizes besitzen.

Maskenbänder mit partiell ausgeformten Bereichen mit transparenten und reflektiven Eigenschaften werden hierbei beispielsweise von einer Trägerschicht, einer partiell ausgeformten reflektiven Schicht und einer optionalen Schutzlackschicht gebildet. Die reflektive Schicht kann hierbei beispielsweise von einer dünnen Metallschicht oder von einer HRI-Schicht (HRI = High Refraction Index) gebildet werden. Eine absorptive Schicht kann hierbei beispielsweise von einer musterförmig aufgebrachten Farbschicht gebildet werden.

Es ist natürlich auch möglich, Maskenbänder einzusetzen, die Bereiche mit unterschiedlichen transparenten/reflektiven Eigenschaften, unterschiedlichen Polarisationseigenschaften und unterschiedlichen optischen Brechungsindizes besitzen. So ist es möglich, in dem Maskenband 22 eine zusätzliche, partiell ausgeformte reflektive Schicht vorzusehen, mittels der weitere Bereiche mit transparenten und reflektiven Eigenschaften realisiert werden können. Auch ist es möglich, in einem Maskenband eine Replizierschicht mit einer eingeprägten diffraktiven Struktur vorzusehen, durch die spezielle beugungsoptische Effekte, beispielsweise Verstärkung und Auslöschung, erzielt werden.

Fig. 3 zeigt eine Draufsicht auf das Maskenband 2 im Belichtungsbereich 18. Wie in Fig. 3 erkennbar, weist das Maskenband 2 hier mehrere Musterbereiche 23, 24, 25 und 26 auf. In jedem Musterbereich 23 bis 26 ist das Maskenband 2 gleichartig ausgestaltet, so dass ein und dasselbe Muster aus partiell ausgeformten Bereichen mit unterschiedlichen optischen Eigenschaften in jedem der Musterbereiche 23 bis 26 wiederholt wird.

Der Musterbereich 23 besteht beispielhaft aus vier Bereichen, in denen das Maskenband 2 unterschiedliche optische Eigenschaften besitzt.

In einem ersten Bereich wird das von der Strahlungsquelle 11 einfallende Licht in einer zur Senkrechten um 45° geneigten Richtung linear polarisiert, in einem zweiten Bereich in um 80° gegenüber der Senkrechten geneigten Richtung linear polarisiert, in einem dritten Bereich in senkrechter Richtung linear polarisiert und in einem vierten Bereich um 135° gegenüber der Senkrechten geneigten Richtung linear polarisiert.

Die vier Bereiche können in Form von Bildern, graphischen Darstellungen, Zahlen oder Buchstaben ausgeformt sein.

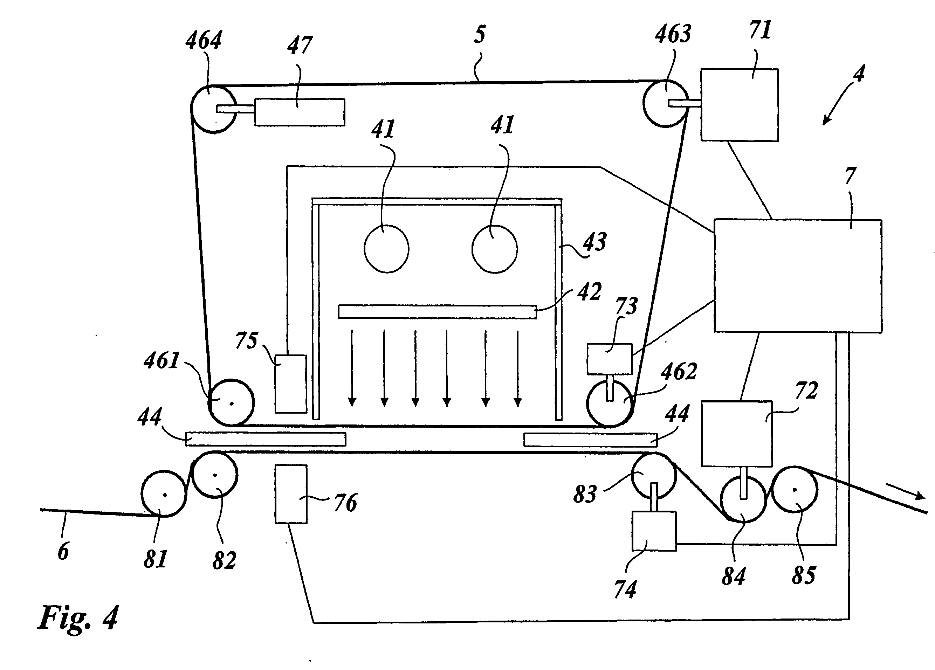

Anhand von Fig. 4 werden nun weitere Möglichkeiten des Aufbaues einer erfindungsgemässen Belichtungsstation erläutert:

Fig. 4 zeigt eine schematische Darstellung einer Belichtungsstation 4 mit einem Maskenband 5, mehreren Rollen 464, 463, 462 und 461 zur Führung des Maskenbandes, zwei Strahlungsquellen 41, einem Abschirmgehäuse 43, einem Kollimator 42, einer Spannvorrichtung 47, zwei Antriebseinrichtungen 71 und 72, mehreren Sensoren 75, 73, 76 und 74, einer Steuereinrichtung 7, mehreren Rollen 81, 82, 83, 84 und 85 zur Führung einer Folienbahn 6 und zwei Abschirmblechen 44.

Wie in Fig. 4 gezeigt, sind das Maskenband 5 und die Folienbahn 6 in dem Belichtungsbereich nicht mehr übereinander liegend, sondern voneinander beabstandet geführt. Der Abstand des Maskenbandes 5 von der Folienbahn 6 im Belichtungsbereich beträgt hier ca. 1 cm, kann sich jedoch in einem Bereich von dem Bruchteil eines Millimeters bis zu mehreren Zentimetern bewegen. Entscheidend hierfür ist die Qualität des Kollimators 42.

Das Abschirmgehäuse 43 und die Abschirmbleche 44 sorgen dafür, dass die Strahlung der Strahlungsquellen 41 von den Bereichen der Folienbahn 6 abgeschirmt wird, die sich nicht im Belichtungsbereich befinden.

Das Maskenband 5 wird über die Rollen 461, 462, 463 und 464 geführt. Die Rolle 464 ist mit der Spannvorrichtung 47 verbunden, die beispielsweise von einem Federelement oder von einer Spannvorrichtung gemäss der Spannvorrichtung 17 nach Fig. 1 gebildet wird. Die Rolle 463 ist mit der Antriebseinrichtung 71 verbunden, so dass das Maskenband 5 aufgrund der durch die Drehung der Rolle 463 durch die Antriebseinrichtung 71 in Pfeilrichtung bewegt wird. Bei der Antriebseinrichtung 71 handelt es sich beispielsweise um einen Elektromotor, der über ein Getriebe mit der Rolle 463 verbunden ist. Die Rolle 462 ist mit dem Sensor 73 verbunden, bei dem es sich beispielsweise um einen inkrementalen Geber handelt, der die Drehung der Rolle 462 in Spannungsimpulse umsetzt.

Die Folienbahn 6 wird über die Rollen 81, 82, 83, 84 und 85 geführt. Die Rolle 84 ist hierbei mit der Antriebseinrichtung 72 verbunden. Bei der Antriebseinrichtung 72 handelt es sich beispielsweise um einen Elektromotor der über ein Zahnriemengetriebe mit der Rolle 64 verbunden ist. Durch Drehung der Rolle 84 wird die Folienbahn 6 in Pfeilrichtung bewegt. Die Rolle 83 ist mit dem Sensor 74 verbunden, bei dem es sich ebenfalls um einen inkrementalen Geber handelt, der die Drehbewegung der Rolle 83 in Spannungsimpulse umsetzt.

Weiter verfügt die Belichtungsstation über optische Sensoren 75 und 76, mittels denen auf dem Maskenband 5 und auf der Folienbahn 6 angebrachte optische Markierungen erfasst werden. Auf die Sensoren 75 und 76 könnte auch verzichtet werden.

Die Steuerung 7 steuert und regelt den von der Belichtungsstation 4 durchgeführten Belichtungsprozess. Die Steuereinrichtung 7 ist mit den Antriebseinrichtungen 71 und 72 und mit den Sensoren 75, 76, 73 über Steuerleitungen verbunden.

Die Steuereinrichtung 7 erfasst über die Sensoren 73 und 74 die Bewegung und die Geschwindigkeit des Maskenbandes 5 bzw. die Bewegung und die Geschwindigkeit der Folienbahn 6. So werden aus den von den Sensoren 73 und 78 abgegebenen Spannungsimpulsen Drehrichtung, Position und Geschwindigkeit des Maskenbandes 5 bzw. der Folienbahn 6 berechnet. Sodann steuert sie mittels eines elektronischen Regelkreises die Antriebseinrichtungen 71 und 74 derart an, dass das Maskenband 5 und die Folienbahn 6 in dem Belichtungsbereich mit derselben Geschwindigkeit und in dieselbe Richtung bewegt werden.

Hierbei ist es möglich, dass die Geschwindigkeit der Folienbahn oder die Geschwindigkeit des Maskenbandes vorgegeben und die Geschwindigkeit des Maskenbandes bzw. der Folienbahn entsprechend dieser vorgegebenen Geschwindigkeit synchronisiert wird. Es ist jedoch auch möglich, dass die Geschwindigkeit der Folienbahn von einer anderen Steuereinrichtung bestimmt wird, die auch die Antriebseinrichtung 72 ansteuert. In diesem Falle wird von der Steuereinrichtung 7 lediglich die Geschwindigkeit der Folienbahn 6 sowie die Geschwindigkeit des Maskenbandes 5 bestimmt und dann die Antriebseinrichtung 71 entsprechend angesteuert, um eine Synchronisation der beiden Geschwindigkeiten zu erreichen.

Auf die Anordnung einer Antriebseinrichtung 72 in der Belichtungsstation 4 kann natürlich auch verzichtet werden.

Weiter ist auch eine mechanische Kopplung der Rollen 463 und 84 möglich, so daß auf die Antriebseinrichtungen 71 und 72 verzichtet werden kann oder diese beiden Antriebseinrichtungen durch eine einzige Antriebseinrichtung ersetzt werden können.

Mittels der optischen Sensoren 75 und 76 werden Markierungen auf dem Maskenband 5 und der Folienbahn 6 erkannt, die genaue Angaben über die Position des Maskenbandes 5 bzw. der Folienbahn 6 vermitteln.

Aufgrund der elektrischen Signale von den Sensoren 75 und 76 ist es der Steuereinrichtung 7 möglich, die genaue, absolute Position des Maskenbandes 5 und der Folienbahn 6 zueinander zu bestimmen und damit zu ermitteln, ob die Belichtung im Register erfolgt oder nicht erfolgt. Die Steuereinrichtung 7 ermittelt, ob derartige Abweichungen bestehen und steuert dann die Antriebseinrichtung 71 entsprechend an, um die Position des Maskenbandes 5 zur Folienbahn 6 derart zu verändert, dass die Belichtung wieder im Register erfolgt. Insofern wirken die Steuereinrichtung 7 und die Sensoren 75 und 76 als Insetting-Vorrichtung, die die Position des Maskenbandes 5 zur Folienbahn 6 derart verändert, dass die Belichtung im Register erfolgt.

Auf diese Funktion der Steuereinrichtung 7 und auf die Sensoren 75 und 76 könnte natürlich auch verzichtet werden.

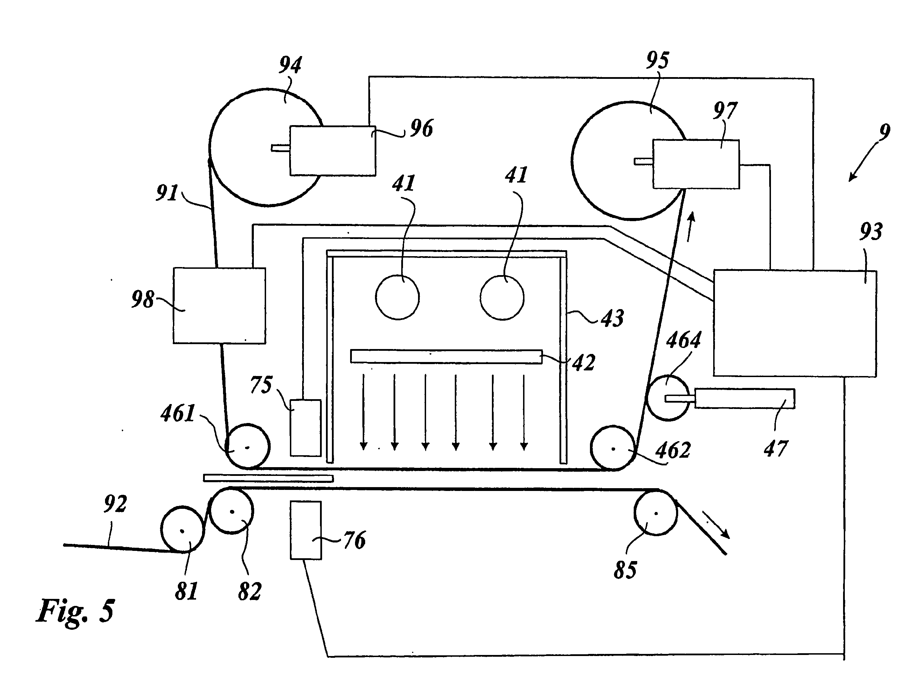

Anhand von Fig. 5 werden nun weitere Möglichkeiten des Aufbaues einer erfindungsgemässen Belichtungsstation erläutert:

Fig. 5 zeigt eine schematische Darstellung einer Belichtungsstation 9 mit einem Maskenband 91, den Rollen 464, 462 und 461 zur Führung des Maskenbandes, zwei Strahlungsquellen 41, dem Abschirmgehäuse 43, dem Kollimator 42, der Spannvorrichtung 47, zwei Antriebseinrichtungen 96 und 97, den Sensoren 75 und 76, einer Steuereinrichtung 93, den Rollen 81, 82 und 85 zur Führung einer Folienbahn 92, zwei Rollen 94 und 95 zum Ab- bzw. Aufwickeln des Maskenbandes 91 und eine digitale Druckeinrichtung 98.

Wie in Fig. 5 gezeigt, ist das Maskenband 91 kein Endlosband, sondern ein offenes Maskenband, das von einer ersten, das Maskenband abspulenden Rolle 94 zu einer zweiten, das Maskenband aufwickelnden Rolle 95 geführt ist.

Die Folienbahn 92 wird über die Rollen 81, 82 und 85 geführt. Die Folienbahn 92 wird hierbei durch eine in Fig. 5 nicht gezeigte Antriebseinrichtung in Pfeilrichtung bewegt.

Das Maskenband 91 wird über die Rollen 461, 462 und 464 von der Rolle 94 zu der Rolle 95 geführt. Die Rolle 464 ist mit der Spannvorrichtung 47 verbunden, die beispielsweise von einem Federelement oder von einer Spannvorrichtung gemäß der Spannvorrichtung 17 nach Fig. 1 gebildet wird. Die Rollen 94 und 95 sind mit den Antriebseinrichtungen 96 bzw. 97 verbunden, die von der Steuereinrichtung 93 angesteuert werden und das Maskenband in Pfeilrichtung bewegen. Die Steuereinrichtung 93 synchronisiert hierbei die Antriebseinrichtungen 96 und 97, so dass das Maskenband 91 mit konstanter Geschwindigkeit bewegt wird. Es ist auch möglich, auf die Antriebseinrichtung 96 zu verzichten oder eine weitere von einer Antriebseinrichtung angetriebene Rolle vorzusehen, die das Maskenband 91 entsprechend der Antriebseinrichtung 73 nach Fig. 4 bewegt. Weiter ist es auch möglich, das Maskenband 91 wie in Fig. 1 gezeigt mit der Folienbahn 92 zu koppeln.

Weiter verfügt die Belichtungsstation über die optischen Sensoren 75 und 76, mittels denen auf dem Maskenband 91 und auf der Folienbahn 92 angebrachte optische Markierungen erfasst werden.

Die Steuerung 93 steuert und regelt den von der Belichtungsstation 9 durchgeführten Belichtungsprozess. Die Steuereinrichtung 93 ist mit den Antriebseinrichtungen 96 und 97 und mit den Sensoren 75 und 76 über Steuerleitungen verbunden. Mittels der Sensoren 75 und 76 wird die Bewegung und die Geschwindigkeit des Maskenbandes 91 bzw. die Bewegung und die Geschwindigkeit der Folienbahn 92 sowie die Phasenlage des Maskenbandes 91 zu der Folienbahn 92 ermittelt. Die Geschwindigkeit der Folienbahn 92 und des Maskenbandes 93 bilden die Eingangsgrößen eines die Antriebseinrichtungen 96 und 97 ansteuernden elektronischen Regelkreises, der bewirkt, dass das Maskenband 91 in dem Belichtungsbereich mit derselben Geschwindigkeit und in dieselbe Richtung wie die Folienbahn 92 bewegt wird. Die Phasenlage des Maskenbandes 91 zu der Folienbahn 92 dient als Eingangsgröße eines weiteren Regelkreises, der die Phasenlage des Maskenbandes 91 ständig mit der Phasenlage der Folienbahn 92 synchronisiert, so dass die Belichtung im Register erfolgt.

Die digitale Druckvorrichtung 98 dient dem Bedrucken der Belichtungsmaske 98 mit ein oder mehreren personalisierten Musterbereichen. So wird von der Druckvorrichtung 98 das Maskenband 91 beispielsweise musterförmig mit einer das von den Lampen 41 abgestrahlte Licht absorbierenden Farbe nach Art eines Laserdruck-Verfahrens bedruckt. Das Maskenband 91 kann in seinem Aufbau hierbei dem Aufbau nach den Figuren 2 und 3 entsprechen. Auf dem Belichtungsband 91 vorgefertigte Musterbereiche können hierbei von von der Druckvorrichtung 98 aufgebrachten, personalisierenden Musterbereichen überlagert werden.

Anstelle des Bedruckens des Maskenbandes 91 ist es auch möglich, das Maskenband mittels eines Lasers zur Personalisierung partiell zu verfärben.

Es ist natürlich auch möglich, auf die Druckvorrichtung 98 zu verzichten. Weiter ist es möglich, die Druckvorrichtung 98 auch in den Belichtungsstationen nach Fig. 1 und Fig. 4 zu verwenden und die aufgedruckte Farbe nach der Belichtung wieder vom Maskenband zu entfernen.

## Patentansprüche

1. Belichtungsstation (1, 4) für die Erzeugung von partiell ausgebildeten Bereichen in einer oder in mehreren Schichten einer Folienbahn (3, 6), wobei die Belichtungsstation (1, 4) eine oder mehrere Strahlungsquellen (11, 41) zur Belichtung der Folienbahn (3, 6) aufweist, wobei die Belichtungsstation (1, 4) ein Maskenband (2, 5) mit partiell ausgeformten Bereichen mit unterschiedlichen optischen Eigenschaften aufweist, wobei die Belichtungsstation (1, 4) zwei oder mehr Führungen (181, 182, 183, 184; 461, 462, 82, 83) zur Führung des Maskenbandes (2, 5) und/oder zur Führung der Folienbahn (3, 6) aufweist, die so angeordnet sind, dass das Maskenband (2, 5) in einem Belichtungsbereich im Strahlungsgang zwischen den ein oder mehreren Strahlungsquellen (11, 41) und der Folienbahn (3, 6) geführt ist, und wobei die Belichtungsstation (1, 4) Kopplungsmittel (182, 183; 7) zur Bewegung des Maskenbandes (2, 5) im Belichtungsbereich mit der Geschwindigkeit der Folienbahn (3, 6) aufweist,
**dadurch gekennzeichnet,**
**dass** das Maskenband (2, 5) eine Trägerschicht (221) aus für Strahlung der einen oder mehreren Strahlungsquellen (11, 41) durchlässigem Material aufweist, und
**dass** das Maskenband (2, 5)
a) partiell ausgeformte Bereiche mit unterschiedlichen optischen Brechungsindizes besitzt und/oder
b) partiell ausgeformte Bereiche (231, 232, 233, 234) mit unterschiedlichen Polarisationseigenschaften besitzt und/oder
c) eine partiell ausgeformte reflektive Schicht aufweist, die Bereiche mit unterschiedlichen reflektiven Eigenschaften besitzt.

2. Belichtungsstation nach Anspruch 1,
wobei
die Belichtungsstation (4) eine Insetting-Vorrichtung (7, 75, 76, 71) aufweist, die die Position des Maskenbandes (5) zur Folie (6) derart verändert, dass die Belichtung im Register erfolgt.

3. Belichtungsstation nach Anspruch 1 oder Anspruch 2,
wobei
die Belichtungsstation (1, 4) eine Spannvorrichtung (17, 47) zur Spannung des Maskenbandes (2, 5) aufweist.

4. Belichtungsstation nach einem der vorhergehenden Ansprüche,
wobei
die Kopplungsmittel von mindestens einer Rolle (182, 183) gebildet sind, über die die Folienbahn (3) und das Maskenband (2) übereinanderliegend geführt sind, so dass das Maskenband (2) mit der Folienbahn (3) mittransportiert wird.

5. Belichtungsstation nach Anspruch 4,
wobei
die Kopplungsmittel zwei beidseitig des Belichtungsbereiches angeordnete Rollen (182, 183) zur Führung der Folienbahn (3) und des Maskenbandes (2) und zwei beidseitig des Belichtungsbereiches angeordnete Rollen (181, 184) zur Führung des Maskenbandes und zur Erzeugung eines Anpressdruckes zwischen Maskenband (2) und Folienbahn (3) aufweisen.

6. Belichtungsstation nach einem der Ansprüche 1 bis 3,
wobei
die Belichtungsstation (4) eine Antriebseinrichtung (71) zur Bewegung des Maskenbandes (5) mit einer ersten Geschwindigkeit aufweist und die Kopplungsmittel von einer die Antriebseinrichtung (71) ansteuernden Steuereinrichtung (7) gebildet sind, die die erste Geschwindigkeit mit der Geschwindigkeit der Folienbahn (6) synchronisiert.

7. Belichtungsstation nach einem der vorhergehenden Ansprüche,
wobei
das Maskenband (2, 5) ein Endlosband ist.

8. Belichtungsstation nach einem der Ansprüche 1 bis 6,
wobei
das Maskenband ein offenes Band (91) ist, das von einer ersten, das Maskenband abspulenden Rolle (94) zu einer zweiten, das Maskenband aufwickelnden Rolle (95) geführt ist.

9. Belichtungsstation nach einem der vorhergehenden Ansprüche,
wobei
das Maskenband ein oder mehrere personalisierte Musterbereiche aufweist.

10. Belichtungsstation nach einem der vorhergehenden Ansprüche,
wobei
das Maskenband ein wiederbeschreibbares Maskenband ist.

11. Belichtungsstation nach einem der vorhergehenden Ansprüche,
wobei
das Maskenband (2) einen sich zwei oder mehrfach wiederholenden Musterbereich (23, 24, 25, 26) aufweist.

12. Belichtungsstation nach einem der vorhergehenden Ansprüche,
wobei
das Maskenband partiell ausgeformte Bereiche mit absorbierenden Eigenschaften besitzt.

13. Belichtungsstation nach Anspruch 1,
wobei
das Maskenband in Fall b) einen Bereich aufweist, in dem sich die Polarisationsrichtung, in der das einfallende Licht polarisiert wird, stetig ändert.

14. Belichtungsstation nach Anspruch 1,
wobei
das Maskenband in Fall b) aneinander grenzende Bereiche aufweist, in denen die Polarisationsrichtung, in der das einfallende Licht polarisiert wird, unterschiedlich ist.

15. Belichtungsstation nach Anspruch 1,
wobei
das Maskenband in Fall b) aneinander grenzende Bereiche aufweist, in denen das einfallende Licht polarisiert bzw. nicht polarisiert wird.

16. Belichtungsstation nach einem der vorhergehenden Ansprüche,
wobei
die Belichtungsstation einen optischen Filter, insbesondere einen Polarisator und/oder Bandpass, aufweist, der in dem Strahlengang zwischen den ein oder mehreren Lichtquellen und dem Maskenband angeordnet ist.

17. Belichtungsstation nach einem der vorhergehenden Ansprüche,
wobei
die Belichtungsstation (1, 4) einen Kollimator (13, 42) aufweist, der in dem Strahlengang zwischen den ein oder mehreren Lichtquellen (11, 41) und dem Maskenband (2, 5) angeordnet ist.

18. Belichtungsstation nach einem der vorhergehenden Ansprüche,
wobei
die Strahlungsquelle (11, 41) eine Lichtquelle, insbesondere eine UV-Lampe ist.

19. Belichtungsstation nach einem der vorhergehenden Ansprüche,
wobei
die Belichtungsstation eine Abschirmung (15, 43, 44) aufweist, die so ausgeformt ist, dass sie die Strahlung der Strahlungsquelle (11, 41) von den Bereichen der Folienbahn (3, 6) abschirmt, die sich nicht im Belichtungsbereich befinden.

20. Verwendung einer Belichtungsstation nach einem der vorhergehenden Ansprüche zur Herstellung eines optisch variablen Sicherungselements mit partiell ausgebildeten Bereichen, die unterschiedliche optische Eigenschaften besitzen.

21. Verwendung nach Anspruch 20,
wobei
das optisch variable Element als ein optisches Sicherungselement zur Sicherung von Banknoten, Kreditkarten und dergleichen ausgebildet wird.

22. Verwendung nach Anspruch 20,
wobei
das optisch variable Element als eine Folie, insbesondere eine Prägefolie, Laminierfolie oder Stickerfolie ausgebildet wird.

## Claims

1. Exposure station (1, 4) for producing partially formed regions in one or more layers of a film web (3, 6), wherein the exposure station (1, 4) has one or more radiation sources (11, 41) for exposing the film web (3, 6), wherein the exposure station (1, 4) has a masking belt (2, 5) with partially formed regions with different optical characteristics, wherein the exposure station (1, 4) has two or more guides (181, 182, 183, 184; 461, 462, 82, 83) for guiding the masking belt (2, 5) and/or for guiding the film web (3, 6), which guides are arranged such that the masking belt (2, 5) is guided in an exposure region in the radiation path between the one or more radiation sources (11, 41) and the film web (3, 6), and wherein the exposure station (1, 4) has coupling means (182, 183; 7) for moving the masking belt (2, 5) in the exposure region at the speed of the film web (3, 6), **characterized in that** the masking belt (2, 5) has a carrier layer (221) composed of a material which is transmissive to radiation from the one or more radiation sources (11, 41), and **in that** the masking belt (2, 5)
a) has partially formed regions with different optical refractive indices and/or
b) has partially formed regions (231, 232, 233, 234) with different polarization characteristics and/or
c) has a partially formed reflective layer having regions with different reflective characteristics.

2. Exposure station according to Claim 1, wherein the exposure station (4) has an insetting apparatus (7, 75, 76, 71) which changes the position of the masking belt (5) in relation to the film (6) such that the exposure takes place in register.

3. Exposure station according to Claim 1 or Claim 2, wherein the exposure station (1, 4) has a tensioning apparatus (17, 47) for tensioning the masking belt (2, 5).

4. Exposure station according to one of the preceding claims, wherein the coupling means are formed by at least one roller (182, 183) over which the film web (3) and the masking belt (2) are guided one on top of the other, such that the masking belt (2) is transported together with the film web (3).

5. Exposure station according to Claim 4, wherein the coupling means have two rollers (182, 183) arranged on both sides of the exposure region for guiding the film web (3) and the masking belt (2), and have two rollers (181, 184) arranged on both sides of the exposure region for guiding the masking belt and for producing a contact pressure between masking belt (2) and film web (3).

6. Exposure station according to one of Claims 1 to 3, wherein the exposure station (4) has a drive device (71) for moving the masking belt (5) at a first speed, and the coupling means are formed by a control device (7), which controls the drive device (71) and synchronizes the first speed with the speed of the film web (6).

7. Exposure station according to one of the preceding claims, wherein the masking belt (2, 5) is an endless belt.

8. Exposure station according to one of Claims 1 to 6, wherein the masking belt is an open belt (91) which is guided from a first roller (94), which unreels the masking belt, to a second roller (95), which takes up the masking belt.

9. Exposure station according to one of the preceding claims, wherein the masking belt has one or more personalized patterned regions.

10. Exposure station according to one of the preceding claims, wherein the masking belt is a rewritable masking belt.

11. Exposure station according to one of the preceding claims, wherein the masking belt (2) has a patterned region (23, 24, 25, 26) which is repeated two or more times.

12. Exposure station according to one of the preceding claims, wherein the masking belt has partially formed regions with absorbing characteristics.

13. Exposure station according to Claim 1, wherein the masking belt in case b) has a region in which the polarization direction in which the incident light is polarized continuously changes.

14. Exposure station according to Claim 1, wherein the masking belt in case b) has adjoining regions in which the polarization direction in which the incident light is polarized is different.

15. Exposure station according to Claim 1, wherein the masking belt in case b) has adjoining regions in which the incident light is respectively polarized or not polarized.

16. Exposure station according to one of the preceding claims, wherein the exposure station has an optical filter, in particular a polarizer and/or bandpass filter, which is arranged in the beam path between the one or more light sources and the masking belt.

17. Exposure station according to one of the preceding claims, wherein the exposure station (1, 4) has a collimator (13, 42) which is arranged in the beam path between the one or more light sources (11, 41) and the masking belt (2, 5).

18. Exposure station according to one of the preceding claims, wherein the radiation source (11, 41) is a light source, in particular a UV lamp.

19. Exposure station according to one of the preceding claims, wherein the exposure station has a screen (15, 43, 44) which is designed such that it screens those regions of the film web (3, 6) which are not within the exposure region against the radiation from the radiation source (11, 41).

20. Use of an exposure station according to one of the preceding claims for producing an optically variable security element with partially formed regions having different optical characteristics.

21. Use according to Claim 20, wherein the optically variable element is in the form of an optical security element for security of bank notes, credit cards and the like.

22. Use according to Claim 20, wherein the optically variable element is in the form of a film, in particular an embossing film, laminating film or adhesive film.

## Revendications

1. Poste d'exposition (1, 4) pour générer des zones partiellement réalisées dans une ou plusieurs couches d'une bande de film (3, 6), le poste d'exposition (1, 4) présentant une ou plusieurs sources de rayonnement (11, 41) pour l'exposition de la bande de film (3, 6), le poste d'exposition (1, 4) présentant une bande de masque (2, 5) avec des zones partiellement formées avec différentes propriétés optiques, le poste d'exposition (1, 4) présentant deux guidages ou plus (181, 182, 183, 184, 461, 462, 82, 83) destinés au guidage de la bande de masque (2, 5) et/ou destinés au guidage de la bande de film (3, 6), qui sont disposés de telle manière que la bande de masque (2, 5) est guidée dans une zone d'exposition dans la trajectoire du rayonnement entre la ou les sources de rayonnement (11, 41) et la bande de film (3, 6), et le poste d'exposition (1, 4) présentant des moyens de couplage (182, 183, 7) destinés au déplacement de la bande de masque (2, 5) dans la zone d'exposition à la vitesse de la bande de film (3, 6),
**caractérisé en ce**
**que** la bande de masque (2, 5) présente une couche de support (221) en matériau perméable au rayonnement de la ou des sources de rayonnement (11, 41) et
en ce que la bande de masque (2, 5)
a) possède des zones partiellement formées avec différents index de réfraction optiques et/ou
b) possède des zones partiellement formées (231, 232, 233, 234) avec différentes propriétés de polarisation et/ou
c) présente une couche réfléchissante partiellement formée qui possède des zones avec différentes propriétés réfléchissantes.

2. Poste d'exposition selon la revendication 1,
le poste d'exposition (4) présentant un dispositif d'insertion (7, 75, 76, 71) qui modifie la position de la bande de masque (5) par rapport au film (6) de telle manière que l'exposition a lieu dans le registre.

3. Poste d'exposition selon la revendication 1 ou la revendication 2,
le poste d'exposition (1, 4) présentant un dispositif de fixation (17, 47) destiné à la fixation de la bande de masque (2, 5).

4. Poste d'exposition selon l'une quelconque des revendications précédentes,
les moyens de couplage étant formés par au moins un rouleau (182, 183), sur lequel la bande de film (3) et la bande de masque (2) sont guidées l'une sur l'autre, de telle manière que la bande de masque (2) est transportée avec la bande de film (3).

5. Poste d'exposition selon la revendication 4,
le moyen de couplage présentant deux rouleaux (182, 183) disposés des deux côtés de la zone d'exposition pour le guidage de la bande de film (3) et de la bande de masque (2) et deux rouleaux (181, 184) disposés des deux côtés de la zone d'exposition pour le guidage de la bande de masque et pour la génération d'une pression d'appui entre la bande de masque (2) et la bande de film (3).

6. Poste d'exposition selon l'une quelconque des revendications 1 à 3,
le poste d'exposition (4) présentant un dispositif d'entraînement (71) destiné au déplacement de la bande de masque (5) à une première vitesse et les moyens de couplage étant formés d'un dispositif de commande (7) qui amorce le dispositif d'entraînement (71) et synchronise la première vitesse avec la vitesse de la bande de film (6).

7. Poste d'exposition selon l'une quelconque des revendications précédentes,
la bande de masque (2, 5) étant une bande infinie.

8. Poste d'exposition selon l'une quelconque des revendications 1 à 6,
la bande de masque étant une bande ouverte (91) guidée par un premier rouleau (94) qui déroule la bande de masque vers un deuxième rouleau (95) qui enroule la bande de masque.

9. Poste d'exposition selon l'une quelconque des revendications précédentes,
la bande de masque présentant une ou plusieurs zones de motifs personnalisées.

10. Poste d'exposition selon l'une quelconque des revendications précédentes,
la bande de masque étant une bande de masque réinscriptible.

11. Poste d'exposition selon l'une quelconque des revendications précédentes,
la bande de masque (2) présentant une zone de motifs (23, 24, 25, 26) qui se répète deux ou plusieurs fois.

12. Poste d'exposition selon l'une quelconque des revendications précédentes,
la bande de masque possédant des zones partiellement formées dotées de propriétés absorbantes.

13. Poste d'exposition selon la revendication 1, la bande de masque présentant dans le cas b) une zone, dans laquelle le sens de polarisation de la lumière incidente change constamment.

14. Poste d'exposition selon la revendication 1, la bande de masque dans le cas b) présentant des zones adjacentes, dans lesquelles le sens de polarisation de la lumière incidente est différent.

15. Poste d'exposition selon la revendication 1, le bande de masque dans le cas b) présentant des zones adjacentes, dans lesquelles la lumière incidente est polarisée et/ou n'est pas polarisée.

16. Poste d'exposition selon l'une quelconque des revendications précédentes,
le poste d'exposition présentant un filtre optique, en particulier un polarisateur et/ou un passe-bande qui est disposé dans la trajectoire du rayon entre la ou les sources lumineuses et la bande de masque.

17. Poste d'exposition selon l'une quelconque des revendications précédentes,
le poste d'exposition (1, 4) présentant un collimateur (13, 42), qui est disposé dans la trajectoire du rayon entre la ou les sources lumineuses (11, 41) et la bande de masque (2, 5).

18. Poste d'exposition selon l'une quelconque des revendications précédentes,
la source de rayonnement (11, 41) étant une source lumineuse, en particulier une lampe UV.

19. Poste d'exposition selon l'une quelconque des revendications précédentes,
le poste d'exposition présentant un blindage (15, 43, 44) formé de telle manière qu'il isole le rayonnement de la source de rayonnement (11, 41) des zones de la bande de film (3, 6), qui ne se trouvent pas dans la zone d'exposition du film.

20. Utilisation d'un poste d'exposition selon l'une quelconque des revendications précédentes pour fabriquer un élément de sécurité variable sur le plan optique avec des zones partiellement formées, qui possèdent différentes propriétés optiques.

21. Utilisation selon la revendication 20,
l'élément variable sur le plan optique étant réalisé sous forme d'élément de sécurité optique destiné à la protection de billets de banque, de cartes de crédit et d'objets semblables.

22. Utilisation selon la revendication 20,
l'élément variable sur le plan optique étant réalisé sous forme de film, en particulier de film d'estampage, de film de laminage ou de film autocollant.
